# EUROPEAN PATENT APPLICATION

(11) **EP 2 653 584 A1**
(43) Date of publication of application: **23.10.2013**
(21) Application number: 11848594.5
(22) Date of filing: 19.01.2011
(51) Int. Cl.: C23C 14/24

(54) **VAPOR DEPOSITION SHADOW MASK SYSTEM FOR BACKPLANE AND DISPLAY SCREEN WITH ANY SIZE AND METHOD THEREOF**

(30) Priority: 16.12.2010 CN 201010591718
(71) Applicant: Pan, Chongguang, Wuhan, Hubei 430100 (CN)
(72) Inventor: Pan, Chongguang, Wuhan, Hubei 430100 (CN)
(74) Representative: Chaillot, Geneviève
(86) International application number: PCT/CN2011/070395
(87) International publication number: WO 2012/079294

(57) **Abstract**

The present invention discloses a vapor deposition shadow mask system for backplane and display screen of any size and a method thereof. The system includes at least one vacuum chamber (13A, 13B, 13C and 13D), a substrate (10) and a transmission device. The vacuum chambers (13A, 13B, 13C and 13D) accommodate 'M' set of shadow mask plates (11a, 11b, 11c and 11d) and deposition sources therein. The substrate (10) includes 'M' number of elementary units, each of which being partitioned into 'N' number of regions. The transmission device is utilized to shift the substrate (10) or the shadow mask plate along a path of the vacuum chamber such that the 'M' set of shadow mask plates are corresponded to the different regions of the 'M' number of elementary units in 'N' number of periods. The 'M' is a natural number greater than or equal to one, and the 'N' is a natural number greater than or equal to two.

## Description

### BACKGROUND OF THE INVENTION

### Field of the Invention

The present invention relates to the field of backplanes and display screens, and in concrete relates to a vapor deposition shadow mask system and method thereof for forming a backplane and a display screen with any size.

### Description of the Related Art

Photo-etching techniques are presently the main stream to manufacture display screens and backplanes in the world, and the produced maximum sizes of the display screen and the backplane are determined by the size of photo-etching machines and substrate material. The other conventional techniques, except that the display screens and backplanes provided therefrom cannot have sizes greater than the upper limit of size of those made from the photo-etching machines, cannot immediately offer special backplanes and the display screens according to the customers' specifications. Furthermore, in these conventional techniques, there still have many technical difficulties to be confronted and improved, such as large dimension of investment, large occupancy area, high-level environment requirement, simple product property and long production time.

Vaporized deposition shadow mask plate techniques have been applied in micro electronic manufacturing process for many years. Although the photo-etching technique are much cheaper than that of the vaporized deposition shadow mask plate technique, the vaporized deposition shadow mask plate technique is still the main stream for manufacturing the larger-sized backplanes in the related fields.

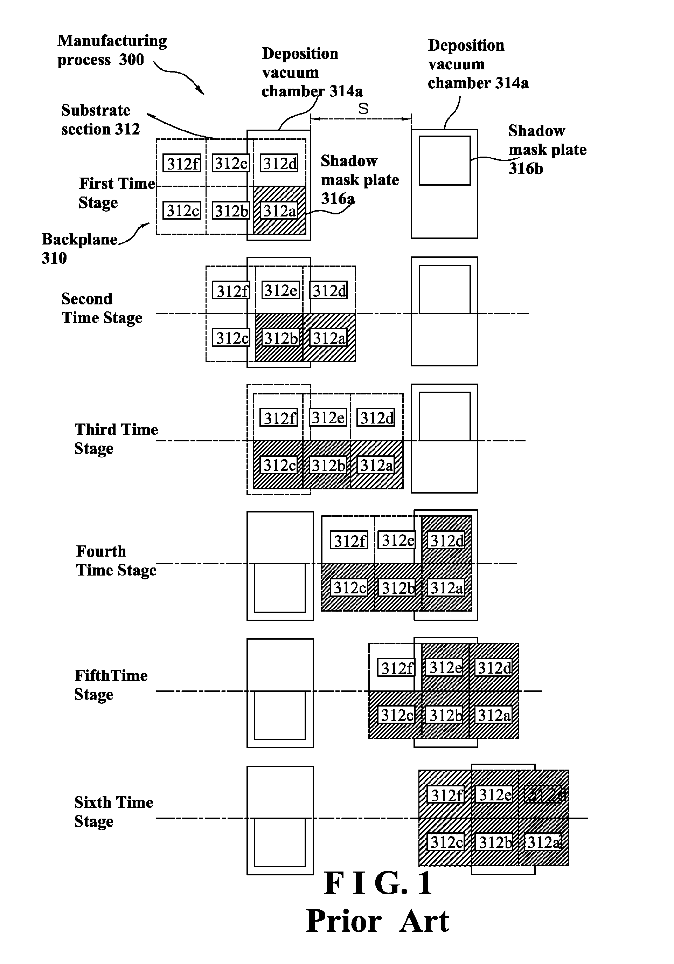

To overcome the above-described difficulties, China Invention Patent Publication No. CN10102742 4B discloses a system and method for manufacturing large-sized backplanes by using the small-area shadow mask plates. In Fig. 1 of '742 case, a typical manufacturing technique 300 is utilized to sequentially form a 3×2 matrix backplane 310 with substrate sections 312a, 312b, 312c, 312d, 312e and 312f by the shadow mask plate deposition technique applied in the continuously arranged deposition vacuum chambers 314a and 314b. The deposition vacuum chambers 314a and 314b respectively include shadow mask plates 316a and 316b, utilizing to form a multilayer backplane 310 by performing several deposition processes on the continuously arranged substrate section 312. Specifically, at First Time Stage, the deposition process is performed on the substrate section 312a in the deposition vacuum chamber 314a by the use of the shadow mask plate 316a. Then, the substrate is moved and aligned, such that at Second Time Stage the deposition process is performed on the substrate section 312b in the deposition vacuum chamber 314a by the use of the shadow mask plate 316a. Then, the substrate is moved and aligned, such that at Third Time Stage the deposition process is performed on the substrate section 312c in the deposition vacuum chamber 314a by the use of the shadow mask plate 316a. When the deposition processes on the row of the substrate sections 312a, 312b and 312c are completed, the substrate is moved to the deposition vacuum chamber 314b, wherein the shadow mask plate 316b is disposed relative to the shifting position of the shadow mask plate 316a so as to form the next row of the substrate section 312. At Fourth Time Stage, the deposition process is performed on the substrate section 312d in the deposition vacuum chamber 314b by the use of the shadow mask plate 316b. Then, the substrate is moved and aligned, such that at Fifth Time Stage the deposition process is performed on the substrate section 312e in the deposition vacuum chamber 314b by the use of the shadow mask plate 316b. Then, the substrate is moved and aligned, such that at Sixth Time Stage the deposition process is performed on the substrate section 312f in the deposition vacuum chamber 314b by the use of the shadow mask plate 316b.

In actual applications, the small-area shadow mask plates can be utilized to manufacture the large-area backplane, but there still have some following shortages.

First, the operation of the manufacturing system for the large-area backplane too lengthy. In the deposition process, the large-area backplane is generally partitioned into multiple rows and columns, and multiple continuously-arranged deposition chambers shall be correspondingly arranged therewith, so that the formation of the backplane can be realized. Furthermore, the configuration of the positioning mechanism between the shadow mask plates and the substrates is very complicated due to the high deposition frequencies of the large-area backplane, and poor connection performances or disengagements caused by the inaccuracy positioning between the shadow mask plates and the substrate sections are easily occurred. Generally, each of the deposition sources corresponding to the shadow mask plates is designated to deposit all substrate sections in one row or column. When depositing the backplane formed with unequal rows and columns or a large-area one, it is correspondingly difficult to supplement materials to the deposition sources.

### BRIEF SUMMARY OF THE INVENTION

In view of this, the present invent is submitted to overcome the difficulties in the conventional methods for manufacturing the backplane and the display screen.

The first purpose of the present is to provide a vapor deposition shadow mask system for a backplane and a display screen with any size, avoiding the lengthy operation of the manufacturing system for the large-area backplane, poor connection performances or disengagements caused by the inaccuracy positioning between the shadow mask plates and the substrate sections, and difficulties of materials supplemented to the deposition sources.

To attain the purpose above, the present invention provides the following solutions.

A vapor deposition shadow mask system for a backplane and a display screen with any size is provided. The vapor deposition shadow mask system comprises at least one vacuum chamber, a substrate and a transmission device. The vacuum chamber is utilized to accommodate 'M' set of shadow mask plates and deposition sources therein. The substrate comprises 'M' number of elementary units, each of which being partitioned into 'N' number of regions. The transmission device is utilized to shift the substrate or the shadow mask plate along a path of the vacuum chamber such that the 'M' set of shadow mask plates are corresponded to the different regions of the 'M' number of elementary units in 'N' number of periods. The 'M' is a natural number greater than or equal to one, and the 'N' is a natural number greater than or equal to two.

Further, the 'N' is equal to four.

Further, the at least one vacuum chamber comprises 'N' number of serially-connected vacuum chambers, and the transmission device comprises a substrate transmission device.

Further, the amount of the at least one vacuum chamber is one, and the transmission device comprises a shadow mask plate transmission device.

Further, the shadow mask plate system is operable at a position where the shadow mask plates corresponding to the neighboring regions of the elementary units are overlapped to a part of material of the deposition source when the deposition source deposits.

The second purpose of the present is to provide a method for a vaporized deposition shadow mask plate for a backplane and a display screen with any size, characterized in that the method comprises the steps of:

(A) respectively positioning each of sets of shadow mask plates and deposition sources on a first region of each of elementary units in accordance with an operable relationship of between the shadow mask plate which is fully located in a vacuum box and the deposition source;

(B) depositing a material on the first region of each of elementary units by a vaporized deposition;

(C) positioning each of sets of the shadow mask plates and deposition sources on a second region of each of elementary units by a transmission device;

(D) depositing the material on the second region of each of elementary units by the vaporized deposition; and

(E) repeating the steps (C) and (D) to perform depositions to 'N' number of regions of each of elementary units, wherein the 'N' is a natural number greater than or equal to two.

Further, the 'N' is equal to four.

Further, the transmission device comprises a substrate transmission device, 'N' number of serially-connected vacuum boxes, and the different regions of each of the elementary units are deposited in different vacuum boxes, respectively.

Further, the transmission device comprises a shadow mask plate transmission device, and the number of the vacuum box is one.

Further, when depositing the neighboring regions of the elementary units, the shadow mask plates corresponding to the neighboring regions of the elementary units are overlapped to a part of material of the deposition source when the deposition source deposits.

With the above-described structure of the invention, the following benefits and effects can be obtained.

First, it only has to determine the 'N' number of the vacuum box in accordance with the 'N' number of regions of each of the elementary unit if the above deposition process of the present invention is realized by moving the substrate. On the other hand, if the above deposition process of the present invention is realized by moving the shadow mask plate, it only has to move the shadow mask plate within the single vacuum box instead of the conventional skills utilizing large number of vacuum boxes, thus simplifying the whole structure of the deposition system. Further, for manufacturing any backplanes and display screens with any size, the present invention only has to perform the depositions of the 'N' number of regions of each of the elementary unit in 'N' number of period, i.e., four-time movements in the deposition process, thereby avoiding poor connection performance between the adjacent substrate sections caused by high frequency of movement in the deposition process. In addition, if the deposition process is performed by moving the substrate, the present invention only has to perform one-time deposition when forming a shadow mask plate provided with a backplane and a display screen, thereby facilitating the controlling to the deposition materials of the deposition sources.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:

Fig. 1 is a time sequence diagram of a manufacturing process of a conventional vapor deposition shadow mask system;

Fig. 2 is a time sequence diagram of a manufacturing process of a first embodiment of the present invention;

Fig. 3 is a time sequence diagram of a manufacturing process of a second embodiment of the present invention; and

Fig. 4 is a time sequence diagram of a manufacturing process of a second embodiment of the present invention when shadow mask plates are utilized for transmission.

### DETAILED DESCRIPTION OF THE INVENTION

To further explain the technical measures of the present invention, the present invention is described in detail by specific embodiment as follows.

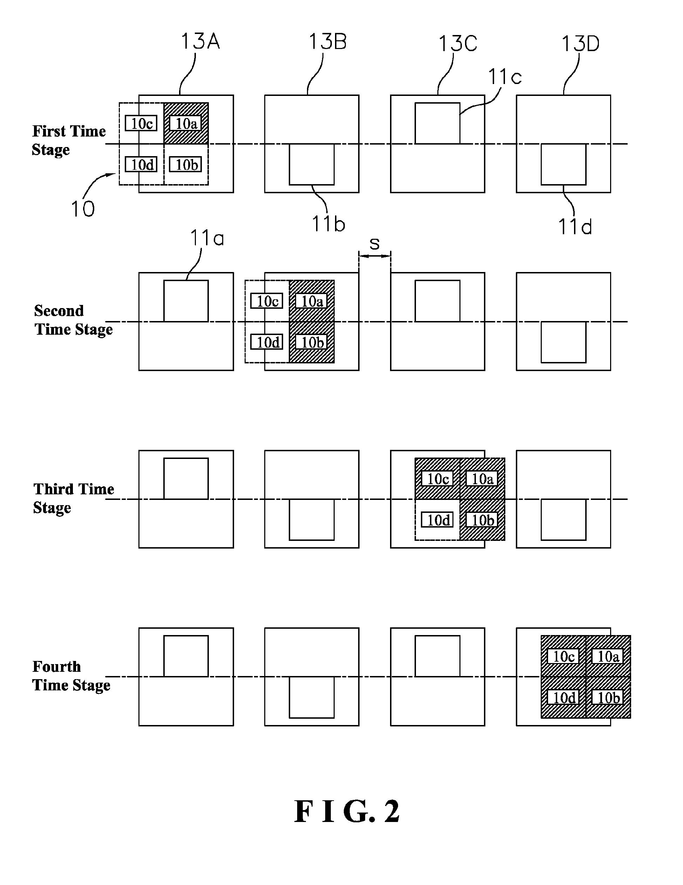

As shown in Fig. 2, a time sequence diagram of a manufacturing process of a vapor deposition shadow mask system of a first embodiment of the present invention is illustrated. The vapor deposition shadow mask system comprises four serially-connected vacuum chambers 13A, 13B, 13C and 13D, a substrate 10 movable in the vacuum chambers 13A, 13B, 13C and 13D, and a transmission device (not shown in FIGs.) utilized to drive the substrate 10 to move along the path of the vacuum chambers 13A, 13B, 13C and 13D for translation displacement. The substrate 10 comprises 'M' number elementary unit partitioned into 'N' number of regions. Each of the vacuum chambers 13A, 13B, 13C and 13D comprises 'M' set of shadow mask plates and deposition sources therein. In this embodiment, the 'M' is equal to one, the 'N' is equal to four, and a backplane with 2×2 matrix can be gradually formed when the four-time depositions are performed.

The detail specific time sequence of the first embodiment of the present invention is described as follows.

At First Time Stage, a substrate section 10a of the substrate 10 is deposited by the use of a shadow mask plate 11a in the vacuum chamber 13A. Then, the substrate 10 is moved by the transmission device into the vacuum chamber 13B to align a shadow mask plate 11b to a substrate section 10b of the substrate 10, and at Second Time Stage the substrate section 10b of the substrate 10 is deposited by the use of the shadow mask plate 11b in the vacuum chamber 13B. Then, the substrate 10 is moved by the transmission device into the vacuum chamber 13C to align a shadow mask plate 11c to a substrate section 10c of the substrate 10, and at Third Time Stage the substrate section 10c of the substrate 10 is deposited by the use of the shadow mask plate 11c in the vacuum chamber 13C. Then, the substrate 10 is moved by the transmission device into the vacuum chamber 13D to align a shadow mask plate 11d to a substrate section 10d of the substrate 10, and at Third Time Stage the substrate section 10d of the substrate 10 is deposited by the use of the shadow mask plate 11d in the vacuum chamber 13D.

With the shadow mask plates 11a, 11b, 11c and 11d disposed in the vacuum chambers 13A, 13B, 13C and 13D above, a backplane with 2×2 matrix can be formed in the time sequence of First, Second, Third and Fourth Time Stages, and it is particularly suitable for small-sized backplanes.

Preferably, the shadow mask plate system is operable at a position where the shadow mask plates corresponding to the neighboring regions of the elementary units are overlapped to a part of material of the deposition source when the deposition source deposits, thereby providing a seaming effect to the backplane. It is needed to explain that the distances 'S' formed between the vacuum chambers 13A, 13B, 13C and 13D can be arbitrarily and suitably adjusted or desired one, thereby eliminating possible interference occurred in the vacuum chambers 13A, 13B, 13C and 13D when the substrate 10 is transmitted therebetween. Therefore, the distances 'S' formed between the vacuum chambers 13A, 13B, 13C and 13D can be zero. In the actual operation, the distances 'S' can be possibly enlarged, thereby allowing half-sized vacuum box and wider-sized substrates in use.

In this embodiment, it is possible to take a single vacuum chamber provided with one set of the shadow mask plate and the deposition source therein, wherein the transmission device is served as a shadow mask plate transmission device. With the shadow mask plate transmission device to drive the substrate 10, the shadow mask plate is enabled to respectively correspond to the different substrate sections 10a, 10b, 10c and 10d of the substrate 10 in the time sequence of First, Second, Third and Fourth Time Stages, so that the deposition is performed four times to form a backplane with 2×2 matrix.

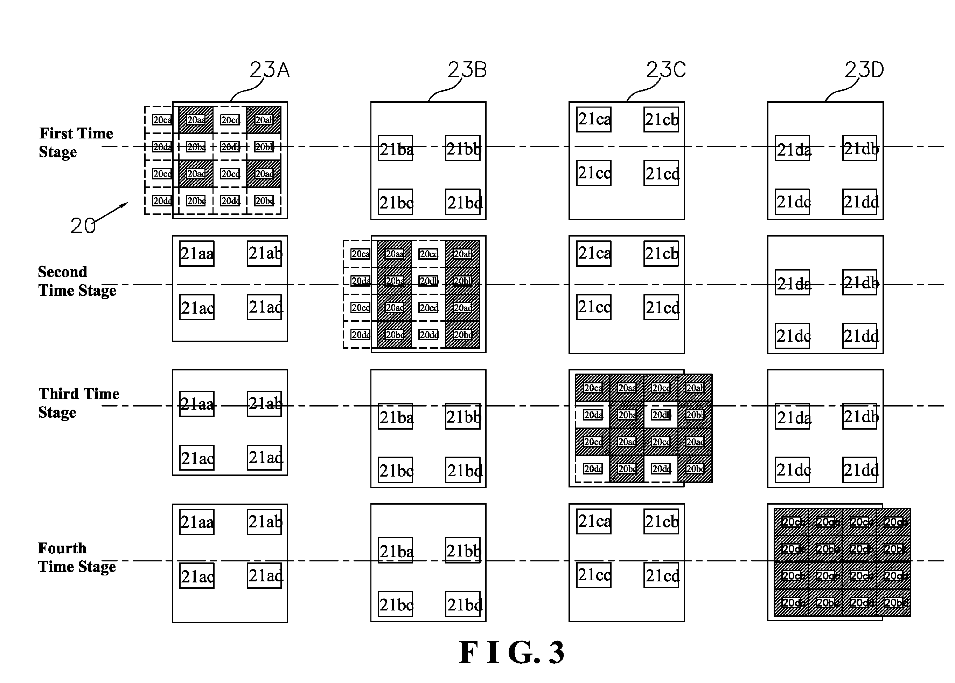

As shown in Fig. 3, a time sequence diagram of a manufacturing process of a vapor deposition shadow mask system of a second embodiment of the present invention is illustrated. The vapor deposition shadow mask system comprises four serially-connected vacuum chambers 23A, 23B, 23C and 23D, a substrate 20 movable in the vacuum chambers 23A, 23B, 23C and 23D, and a transmission device (not shown in FIGs.) utilized to drive the substrate 20 to move along the path of the vacuum chambers 23A, 23B, 23C and 23D for translation displacement. The substrate 20 comprises 'M' number elementary unit, each of which is partitioned into 'N' number of regions. Each of the vacuum chambers 23A, 23B, 23C and 23D comprises 'M' set of shadow mask plates and deposition sources therein. In this embodiment, the 'M' is equal to four, and the 'N' is also equal to four. Four substrate sections 20aa, 20ba, 20ca and 20da constitute a first elementary unit, four substrate sections 20ab, 20bb, 20cb and 20db constitute a second elementary unit, four substrate sections 20ac, 20bc, 20cc and 20dc constitute a third elementary unit, and four substrate sections 20ad, 20bd, 20cd and 20dd constitute a third elementary unit. In this embodiment, a backplane with 4×4 matrix can be gradually formed when the four-time depositions are performed.

The detail specific time sequence of the second embodiment of the present invention is described as follows.

At First Time Stage, the substrate sections 20aa, 20ab, 20ac and 20ad of the substrate 20 are deposited by the use of shadow mask plates 2 1 aa, 21ab, 21ac, and 21ad in the vacuum chamber 23A, wherein the shadow mask plates 2 1 aa, 21ab, 21ac, and 21ad are respectively corresponded to the substrate sections 20aa, 20ab, 20ac and 20ad of the substrate 20.

Then, the substrate 20 is moved by the transmission device into the vacuum chamber 23B to align the shadow mask plates 21ba, 21bb, 21bc and 21bd to the substrate sections 20ba, 20bb, 20bc and 20bd of the substrate 20, and at Second Time Stage the substrate sections 20ba, 20bb, 20bc and 20bd of the substrate 20 are sequentially deposited by the use of the shadow mask plates 21ba, 21bb, 21bc and 21bd in the vacuum chamber 23B.

Then, the substrate 20 is moved by the transmission device into the vacuum chamber 23C to align the shadow mask plates 21ca, 21cb, 21cc and 21cd to the substrate sections 20ca, 20cb, 20cc and 20cd of the substrate 20, and at Third Time Stage the substrate sections 20ca, 20cb, 20cc and 20cd of the substrate 20 are sequentially deposited by the use of the shadow mask plates 21ca, 21 cb, 21cc and 21cd in the vacuum chamber 23C.

Then, the substrate 20 is moved by the transmission device into the vacuum chamber 23D to align the shadow mask plates 21da, 21db, 21dc and 21dd to the substrate sections 20da, 20db, 20dc and 20dd of the substrate 20, and at Fourth Time Stage the substrate sections 20da, 20db, 20dc and 20dd of the substrate 20 are sequentially deposited by the use of the shadow mask plates 21da, 2 1 db, 2 1 dc and 2 1 dd in the vacuum chamber 23D.

Thus, with the shadow mask plates 21aa/21ab/21ac/21ad, 21ba/21bb/21bc/21bd, 21ca/21cb/21cc/21cd and 21da/21db/21dc/21dd respectively disposed in the vacuum chambers 23A, 23B, 23C and 23D above, a backplane with 4×4 matrix can be formed by the continuous deposition in the time sequence of First, Second, Third and Fourth Time Stages. If a large-sized backplane is required, it can be easily achieved only by increasing the number of the substrate sections of the substrate and the number of the shadow mask plates in the vacuum chambers. That is, the aspects of the present invention can be applicable to the manufacturing process of any backplanes and display screens with any size, and therefore the present invention is not limited to the disclosed backplanes with 4×4 and 2×2 matrixes, i.e., the criteria of 'M' can extend to a natural number. The whole deposition process of the backplane can be similarly completed, according to the above-described time sequence of First, Second, Third and Fourth Time Stages and four-time movements in the vacuum chamber. It is understood that the 'N' is not limited to being four as mentioned in the embodiments above, and the 'N' can be a natural number equal to or more than two according to the different requirements.

Preferably, in this embodiment, the shadow mask plate system is operable at a position where the shadow mask plates corresponding to the neighboring regions of the elementary units are overlapped to a part of material of the deposition source when the deposition source deposits, thereby providing a seaming effect to the backplane. It is needed to explain that the distances 'S' formed between the vacuum chambers 23A, 23B, 23C and 23D can be arbitrarily and suitably adjusted or desired one, thereby eliminating possible interference occurred in the vacuum chambers 23A, 23B, 23C and 23D when the substrate 20 is transmitted therebetween. Therefore, the distances 'S' formed between the vacuum chambers 23A, 23B, 23C and 23D can be zero. In the actual operation, the distances 'S' can be possibly enlarged, thereby allowing half-sized vacuum box and wider-sized substrates in use.

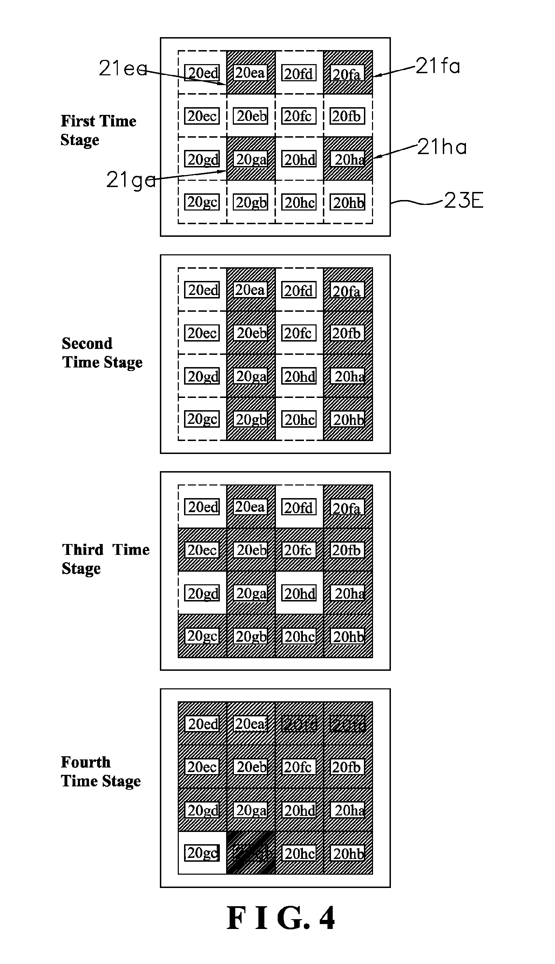

In this embodiment, it is applicable for taking a single vacuum chamber 23E (see Fig. 4) to perform the sequential deposition in the time sequence of First, Second, Third and Fourth Time Stages when moving the shadow mask plates. As shown in Fig. 4, four shadow mask plates 21ea, 21fa, 21ga and 21 ha are disposed in the vacuum chamber 23E, and a substrate comprises four elementary units. In the substrate, four substrate sections 20ea, 20eb, 20ec and 20ed constitute a first elementary unit, four substrate sections 20fa, 20fb, 20fc and 20fd constitute a second elementary unit, four substrate sections 20ga, 20gb, 20gc and 20gd constitute a third elementary unit, and four substrate sections 20ha, 20hb, 20hc 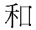 20hd constitute a fourth elementary unit. Therefore, a backplane with 4×4 matrix can be gradually formed in the single vacuum chamber 23E when the four-time depositions are performed.

Accordingly, it only has to determine the 'N' number of the vacuum box in accordance with the 'N' number of regions of each of the elementary unit if the above deposition process of the present invention is realized by moving the substrate. On the other hand, if the above deposition process of the present invention is realized by moving the shadow mask plate, it only has to move the shadow mask plate within the single vacuum box instead of the conventional skills utilizing large number of vacuum boxes, thus simplifying the whole structure of the deposition system. Further, for manufacturing any backplanes and display screens with any size, the present invention only has to perform the depositions of the 'N' number of regions of each of the elementary unit in 'N' number of period, i.e., four-time movements in the deposition process, thereby avoiding poor connection performance between the adjacent substrate sections caused by high frequency of movement in the deposition process. In addition, if the deposition process is performed by moving the substrate, the present invention only has to perform one-time deposition when forming a shadow mask plate provided with a backplane and a display screen, thereby facilitating the controlling to the deposition materials of the deposition sources.

The present invention further provides a method for a vaporized deposition shadow mask plate for a backplane and a display screen with any size, comprising the steps of:

(A) respectively positioning each of sets of shadow mask plates and deposition sources on a first region of each of elementary units in accordance with an operable relationship of between the shadow mask plate which is fully located in a vacuum box and the deposition source; it is concretely that, in the first embodiment the first region is actually referred to the substrate section 10a, and in the second embodiment the first region is actually referred to the substrate sections 20aa, 20ba, 20ca and 20da;

(B) depositing a material on the first region of each of elementary units by a vaporized deposition;

(C) positioning each of sets of the shadow mask plates and deposition sources on a second region of each of elementary units by a transmission device; it is concretely that, in the first embodiment the second region is actually referred to the substrate section 10b, and in the second embodiment the second region is actually referred to the substrate sections 20ab, 20bb, 20cb and 20db;

(D) depositing the material on the second region of each of elementary units by the vaporized deposition; and

(E) repeating the steps (C) and (D) to perform depositions to 'N' number of regions of each of elementary units, wherein the 'N' comprises a natural number greater than or equal to two. In the first and second embodiments, the deposition only reaches to the third and fourth regions.

This is a method wherein the transmission device can be a substrate transmission device, 'N' number of serially-connected vacuum boxes is provided, and the different regions of each of the elementary units are respectively deposited in different vacuum boxes. The transmission device can also be a shadow mask plate transmission device, and the number of the vacuum box is one. For attaining the seaming effect to the backplane, when depositing the neighboring regions of the elementary units, the shadow mask plates corresponding to the neighboring regions of the elementary units are overlapped to a part of material of the deposition source when the deposition source deposits.

As to the substrate having the elementary unit partitioned into regions, it is needed to explain that, the boundary of the configuration of the elementary unit and the regions is considered so obvious but it actually and substantially is not existed.

While this invention has been described in connection with what is presently considered to be the most practical and preferred embodiment, it is to be understood that the invention is not limited to the disclosed embodiments, but, on the contrary, is intended to cover various modifications and equivalent arrangements included within the spirit and scope of the appended claims.

## Claims

1. A vapor deposition shadow mask system for a backplane and a display screen with any size, **characterized in that** the vapor deposition shadow mask system comprises:
at least one vacuum chamber (13A, 13B, 13C and 13D) accommodating 'M' set of shadow mask plates (11a, 11b, 11c and 11d) and deposition sources therein;
a substrate (10) comprising 'M' number of elementary units, each of which being partitioned into 'N' number of regions; and
a transmission device utilized to shift the substrate (10) or the shadow mask plate (11a, 11b, 11c or 11d) along a path of the vacuum chamber such that the 'M' set of shadow mask plates (11a, 11b, 11c and 11d) are corresponded to the different regions of the 'M' number of elementary units in 'N' number of periods;
wherein the 'M' comprises a natural number greater than or equal to one, and the 'N' comprises a natural number greater than or equal to two.

2. The vapor deposition shadow mask system for a backplane and a display screen with any size as claimed in claim 1, **characterized in that** the 'N' is equal to four.

3. The vapor deposition shadow mask system for a backplane and a display screen with any size as claimed in claim 1, **characterized in that** the at least one vacuum chamber (13A, 13B, 13C and 13D) comprises 'N' number of serially-connected vacuum chambers, and the transmission device comprises a substrate transmission device.

4. The vapor deposition shadow mask system for a backplane and a display screen with any size as claimed in claim 1, **characterized in that** the amount of the at least one vacuum chamber (13A, 13B, 13C and 13D) is one, and the transmission device comprises a shadow mask plate transmission device.

5. The vapor deposition shadow mask system for a backplane and a display screen with any size as claimed in claim 1, **characterized in that** the shadow mask plate system is operable at a position where the shadow mask plates corresponding to the neighboring regions of the elementary units are overlapped to a part of material of the deposition source when the deposition source deposits.

6. A method for a vaporized deposition shadow mask plate for a backplane and a display screen with any size, **characterized in that** the method comprises the steps of:
(A) respectively positioning each of sets of shadow mask plates (11a, 11b, 11c and 11d) and deposition sources on a first region of each of elementary units in accordance with an operable relationship of between the shadow mask plate (11a, 11b, 11c or 11d) which is fully located in a vacuum box and the deposition source;
(B) depositing a material on the first region of each of elementary units by a vaporized deposition;
(C) positioning each of sets of the shadow mask plates (11a, 11b, 11c and 11d) and deposition sources on a second region of each of elementary units by a transmission device;
(D) depositing the material on the second region of each of elementary units by the vaporized deposition; and
(E) repeating the steps (C) and (D) to perform depositions to 'N' number of regions of each of elementary units, wherein the 'N' comprises a natural number greater than or equal to two.

7. The method for the vaporized deposition shadow mask plate for the backplane and the display screen with any size as claimed in claim 6, **characterized in that** the 'N' is equal to four.

8. The method for the vaporized deposition shadow mask plate for the backplane and the display screen with any size as claimed in claim 6, **characterized in that** the transmission device comprises a substrate transmission device, 'N' number of serially-connected vacuum boxes, and the different regions of each of the elementary units are deposited in different vacuum boxes, respectively.

9. The method for the vaporized deposition shadow mask plate for the backplane and the display screen with any size as claimed in claim 6, **characterized in that** the transmission device comprises a shadow mask plate transmission device, and the number of the vacuum box is one.

10. The method for the vaporized deposition shadow mask plate for the backplane and the display screen with any size as claimed in claim 6, **characterized in that**, when depositing the neighboring regions of the elementary units, the shadow mask plates (11a, 11b, 11c and 11d) corresponding to the neighboring regions of the elementary units are overlapped to a part of material of the deposition source when the deposition source deposits.
